# EUROPÄISCHE PATENTANMELDUNG

(11) **EP 1 424 751 A2**
(43) Veröffentlichungstag der Anmeldung: **02.06.2004**
(21) Anmeldenummer: 03018441.0
(22) Anmeldetag: 14.08.2003
(51) Int. Cl.: H01R 35/02, H01R 12/08

(54) **Anordnung zur Kontaktierung zwischen zwei Bauelementen**

(30) Priorität: 26.11.2002 DE 10255277
(71) Anmelder: Hesse & Knipps GmbH, 33100 Paderborn (DE)
(72) Erfinder: Hesse, Hans, Dr.-Ing., 33106 Paderborn (DE)
(74) Vertreter: COHAUSZ DAWIDOWICZ HANNIG & PARTNER

(57) **Zusammenfassung**

Die Erfindung betrifft eine Anordnung zur elektrischen Kontaktierung zwischen zwei Bauelementen, wobei ein Bauelement gegenüber dem anderen um eine Drehachse rotierbar ist, insbesondere zur elektrischen Kontaktierung eines rotierbaren Bondkopfes an eine Bondmaschine, wobei die Bauelemente durch wenigstens einen elektrischen Leiter (3) verbunden sind, der, insbesondere spiralförmig, um die Drehachse (8) gewickelt ist. Die Erfindung betrifft weiterhin die Verwendung einer aufgewickelten flexiblen Leiterplatte (1) zur Kontaktierung zwischen den Bauteilen.

## Beschreibung

Die Erfindung betrifft eine Anordnung zur elektrischen Kontaktierung zwischen zwei Bauelementen, wobei ein Bauelement gegenüber dem anderen um eine Drehachse rotierbar ist, insbesondere zur elektrischen Kontaktierung eines rotierbaren Bondkopfes an eine Bondmaschine, bzw ein feststehendes Trägerelement einer Bondmaschine.

Das Problem eine zuverlässige elektrische Verbindung zwischen zwei Bauelementen zu schaffen tritt überall dort auf, wo sich zwei miteinander zu verbindende Bauelemente beliebiger Art relativ zueinander bewegen, sei es durch Translation oder Rotation. Übliche Maßnahmen die Bauelemente durch eine einfache Verkabelung miteinander zu verbinden, weisen nur eine geringe Standzeit auf, da die Kabel bzw. Drähte durch die Bewegung der Bauelemente zueinander, insbesondere bei hohen Zykluszahlen, stark auf Zug, Schub bzw. Torsion beansprucht werden. Hier kann es auf Dauer zur Brüchen innerhalb der Kabel oder auch an den Anschlussstellen kommen.

Eine Vorrichtung, bei der dieses Problem bekannt ist, ist z.B. eine Bondmaschine, bei der sich ein Bondkopf, mit dem Bond-Drahtverbindungen oder auch Flip-Chip-Verbindungen herstellbar sind, gegenüber dem Rest der Bondmaschine, z.B. einem feststehenden Trägerelement bewegt. Um das Bondwerkzeug gegenüber einem Anschlusskontakt in die richtige Position zu bringen ist es vorgesehen, dass der Bondkopf rotierbar gegebenenfalls auch translatierbar aufgehängt ist. Hierbei kann z.B die Drehachse, besonders bei Maschinen zum Drahtbonden durch die Spitze des Werkzeuges verlaufen, die zur Herstellung der Bondverbindungen vorgesehen ist.

Der Bondkopf selbst muss über elektrische Verbindungen an den Rest der Maschine angebunden sein, um z.B. die Spannungsversorgung für den Ultraschallerzeuger zur Verfügung zu stellen, oder auch um Meßwerte oder Daten zu übertragen.

Um eine erhöhte Standzeit der Verbindungsleitungen zwischen Bondkopf und dem Rest der Maschine zu erreichen, ist es bereits aus der DE 196 01 599 bekannt, die einzelnen Drähte um die Drehachse des Bondkopfes herum anzuordnen, wobei die Drähte in der Höhe im wesentlichen in Richtung der Drehachse verlaufen. Die beiden Enden eines Drahtes sind an Kontaktstellen befestigt, die beide etwa den gleichen Abstand von der Drehachse haben, wobei die Drahtlänge eines Drahtes jeweils größer ausgebildet ist als der Abstand zweier Kontakte, die durch einen Draht verbunden werden sollen, so dass ein Draht eine bauchige Aufwölbung bzw. Stauchung aufweist.

Diese bauchige Aufwölbung bildet ein Drahtreservoir, so dass sich der Draht mit zunehmender Rotation des Bondkopfes strecken kann, wobei sich der Draht aufgrund der Rotation gleichzeitig schraubenförmig um die Drehachse wickelt. Da hier die Rotation senkrecht zum jeweils äußersten Drahtende an einer Kontaktstelle, zumindest jedoch immer eine nichtparallele Komponente zur Drahtrichtung aufweist kommt es grundsätzlich zu einer Biegebeanspruchung an den Kontaktstellen, so dass auch bei dieser Ausführung die Standzeit einer solchen Verbindung begrenzt ist.

Aufgabe der Erfindung ist es, eine Anordnung zur elektrischen Kontaktierung zwischen zwei Bauelementen zu schaffen, die durch Vermeidung, zumindest durch starke Reduzierung von Schub-, Zug- und Biegekräften eine weitaus höhere Standzeit erreicht.

Diese Aufgabe wird erfindungsgemäß dadurch gelöst, dass die Bauelemente durch wenigstens einen elektrischen Leiter verbunden sind, der, insbesondere spiralförmig, um die Drehachse gewickelt ist. Diese Art der Führung eines elektrischen Leiters zur Kontaktierung kann besonders bei den genannten Bondmaschinen eingesetzt werden, ist jedoch nicht auf diese Anwendung beschränkt.

Durch die Wicklung eines Leiters um sich selbst herum, insbesondere spiralförmig, kann ein Wickel geschaffen werden, der ein Reservoir an Leitungslänge bereitsstellt, so dass bei entsprechender Leitungslänge bzw. Wicklungsstärke/-zahl sogar mehrfache vollständige Rotationen um 360 Grad möglich werden.

Da die Wicklung in Richtung der Rotation liegt wird sich bei einer Rotation des einen Bauelementes gegenüber dem anderen lediglich eine mehr oder weniger starke weitere Auf- oder Abwicklung eines Leiters, je nach Drehrichtung einstellen. Dies ist vergleichbar mit der Feder in einem klassischen Uhrwerk.

Die Kräfte, die auf die elektrischen Anschlussstellen der jeweiligen Drahtenden wirken, können durch diese Anordnung besonders gering gehalten werden, insbesondere wenn eine große Wicklungszahl realisiert wird. Da die Kräfte in den Anschlussstellen weiterhin lediglich in Richtung der Rotation liegen, kann eine Biegebeanspruchung, zumindest eine sich ständig ändernde Biegebeanspruchung an den Anschlussstellen vermieden werden, insbesondere wenn die elektrischen Leiter in der Rotationsrichtung bzw. tangential hierzu in die Anschlussstelle übergehen. In diesem Fall wird sich lediglich eine sehr geringe Zug- oder Schubbelastung an den Anschlussstellen einstellen, die in der Größe der Federkraft liegt, die sich durch den elastischen Wickel ergibt.

Die Art des elektrischen Anschlusses an einen aufgewickelten Leiter wird bevorzugt so sein, dass ein Leiter mit seinem innerhalb der Wicklung liegenden Ende das eine Bauelement und mit seinem ausserhalb der insbesondere spiralförmigen Wicklung liegenden Ende das andere Bauelement kontaktiert. Hierbei ist aufgrund der Relativbewegung bei der Rotation unerheblich, ob mit Bezug auf den Anwendungsfall bei einer Bondmaschine der Bondkopf oder das feststehende Trägerelement innerhalb des Wickels an den Leiter angeschlossen ist. Insbesondere kann sich eines der beiden Bauelemente mit einem vorspringenden Element bis in den Wickel hinein erstrecken, um so den elektrischen Anschluss an diesem Element zu realisieren.

Besonders vorteilhaft hinsichtlich der Kraftbeanspruchung ist es, wenn die, insbesondere spiralförmige Wicklung eines Leiters innerhalb einer Ebene liegt, die im wesentlichen senkrecht zur Drehachse orientiert ist.

Um z.B. zu verhindern, dass eine spiralförmige Wicklung eines Leiters aufgrund der Schwerkraft, insbesondere in Richtung der Drehachse durchhängt, kann es vorgesehen sein, dass ein Leiter als Flachleiter ausgebildet ist, mit einer Breite die größer ist als seine Dicke, wobei sich ein Leiter in seiner Breite in Richtung der Drehachse erstreckt. Durch diese Dimensionierung eines Leiters kann ein innere Stabilität erreicht werden, da ein Flachprofil um eine Achse senkrecht zu seiner Profilebene, nur eine sehr geringe Tendenz zur Verbiegung aufweist.

Da es oftmals und besonders bei der Anwendung bei einer Bondmaschine nötig ist, mehrere elektrische Signale oder Versorgungsspannungen zwischen den Bauelementen zu verbinden ist es in einer besonders bevorzugten Ausführung vorgesehen, dass die Anordnung eine Vielzahl von Leitern umfasst, die in axialer Richtung nebeneinander angeordnet sind. Es können so mehrere Wicklungen von Leitern in axialer Richtung nebeneinander - mit Bezug auf eine Bondmaschine untereinander - angeordnet sein.

Um hier zu vermeiden, dass die einzelnen Leiter sich bei einer Rotation berühren und dadurch verschleissen, kann es vorgesehen sein, dass die Leiter untereinander isoliert verbunden sind. Somit ergibt sich ein Verbund, der sich nur in seiner Gänze auf- oder weiter abwickeln kann, je nach Drehrichtung. In diesem Verbund können die Leiter einen, insbesondere freitragenden, zylinderförmigen Wickel bilden, durch den die Drehachse verläuft.

Hierbei können die mehrfachen Windungen der Leiter sich untereinander berühren oder aber auch beabstandet sein, wobei die letztgenannte Ausführung die Verschleissneigung nochmals reduziert.

Die Bezeichnung als spiralförmiger Wickel soll lediglich beschreiben, dass die einzelnen Leiter um sich selbst herum aufgewickelt sind, wobei sich mit jeder Wicklung/Windung der Durchmesser des Wickels erhöht, nicht jedoch, dass sich zwischen jeder Windung ein konstanter Abstand einstellt. Dies kann so sein, muss jedoch nicht. Ebenso ist es denkbar, dass der entstehende Wickel eine Leitung oder eine Vielzahl von Leitungen aufweist, die sich von einem inneren Bereich des Wickels sehr schnell zum äußeren Bereich des Wickels erstreckt, wobei alle weiteren Wicklungen berührend aufeinander liegen.

In einer sehr einfachen Ausführungsform können die Leiter als Flachbandkabel ausgebildet sind. Ein solches Flachbandkabel zeihnet sich dadurch aus, dass mehrere insbesondere runde Litze nebeneinader angeordnet sind und untereinander isolierend verbunden sind. Ein solches Flachband lässt sich einfach durch sogenannten Quetschverbinder elektrisch mit den Bauteilen verbinden und um die Drehachse aufwickeln.

In einer bevorzugten Alternative hierzu sind die Leiter als flexible Leiterplatte ausgebildet.

Eine solche flexible Leiterplatte, auch als Flexband bezeichnet, kann z.B. aus dem Basismaterial Polyimide (z.B. Kapton) bestehen, oder aus Polyester oder PEN, wobei letztere Low-Cost-Produkte sind, die nicht alle die hervorragenden Eigenschaften der flexiblen Leiterplatte aus Polyimide besitzen, jedoch im speziellen Fall ausreichend sein können.

So ist die Leiterplatte aus Polyimide sehr hitzebeständig und zeigt keine Veränderungen selbst bei Temperaturen über 250°C. Sie kann wegen der hohen Zugfestigkeit, die größer als die von Stahl sein kann, extrem dünn (½ MIL entspricht 12,5µm) und somit sehr flexibel hergestellt werden. Eine solche flexible Leiterplatte kann auch ohne weiteres durchkontaktiert werden oder Endkontakte aufweisen und somit an ihren Enden problemlos an den Bauteilen elektrisch angeschlossen werden.

Flexible Leiterplatten dieser Art können meist einseitig mit Polyimide-Overlayfolie, die anstelle der Lötstopmaske aufgebracht wird, hergestellt werden. Die Standardmaterialstärke entspricht z.B. 1 MIL (25µm). Mit einer Kupferauflage von 4-35µm, die die Leiterbahnen ausbildet, und einer Kleberstärke von 50µm ist eine typische flexible Leiterplatte etwa 0,18mm dick und somit sehr flexibel.

Neben den zuvorgenannten flexiblen Leiterplatten aus Polyimide können auch solche aus beliebigen anderen Materialien, z.B. neuartige Leiterplatten aus einem "Liquid-Crystal Polymer"-Film (LCP) verwendet werden, der sich durch verbesserte thermische Ausdehnungseigenschaften und geringere Hygroskopie auszeichnet und so Vorteile bei Verarbeitung, Betrieb und Recycling bietet.

Zur Verbindung mit einem Bauteil kann an wenigstens einem Ende der flexiblen Leiterplatte auch eine starre Leiterplatte angeformt sein. Diese starre klassische Leiterplatte kann an einem Bauteil befestigt werden z.B. durch verschrauben und verlöten der Anschlüssem oder einer Bondverbindung.

In einer bevorzugten Weiterbildung dieser Lösung kann eine flexible Leiterplatte z.B. auch zweischenklig ausgebildet sein, wobei einer der Schenkel aufwickelbar ist, um die beschriebenen Vorteile zu erreichen. Der zweite Schenkel kann unter einem rechten Winkel zum ersten ausgebildet sein und dazu dienen, entweder ebenfalls durch Aufwicklung eine Rotation um eine weitere Achse zu ermöglichen oder auch um eine Translationsbewegung eines rotierbaren Bauteiles zusätzlich zu gewährleisten. Hierzu kann der zweite Schenkel einer flexiblen Leiterplatte z.B. einfach z.B. mäanderförmig geführt werden oder in einer Schleife, einer Ausbuchtung etc., um eine Leitungsreserve für eine Translationsbewegung zu liefern.

Ausführungsbeispiele der Erfindung sind in den nachfolgenden Abbildungen dargestellt. Es zeigt:
- Figur 1:: eine Anordnung zur elektrischen Kontaktierung mit einer flexiblen Leiterplatte;
- Figur 2:: eine Anordnung zur elektrischen Kontaktierung mit einer zweischenkligen flexiblen Leiterplatte.

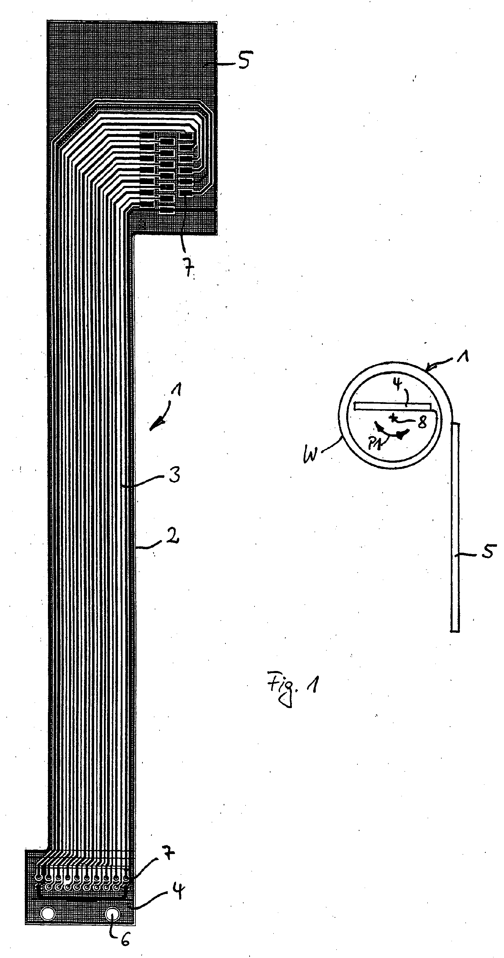

Die Figur 1 zeigt eine flexible Leiterplatte 1 bzw. ein Flexband, welches in üblicher Weise z.B. aus einer Polyimid-Folie 2 ausgebildet ist, auf der Leiterbahnen 3, z.B. aus Kupfer nebeneinander angeordnet sind. An den beiden Endbereichen der flexiblen Leiterplatte sind übliche starre Leiterplatten 4 und 5 angeformt, auf denen sich die Leiterbahnen 3 fortsetzen. Über diese starren Leiterplatten 4 und 5 können die elektrischen Verbindungen zu den Bauelementen hergestellt werden, die es zu verbinden gilt.

Zur Befestigung weist z.B. die starre Leiterplatte 4 Bohrungen 6 auf. Die elektrische Verbindung kann über die Anschlusskontakte 7 auf den starren Leiterplatten 4 und 5 erfolgen, z.B. durch Verlöten, Bonden etc.

Rechts in der Figur 1 ist die Möglichkeit dargestellt, die flexible Leiterplatte 1 mit den vielen Leiterbahnen 3 um die kleine starre Leiterplatte 4 herumzuwickeln, wodurch sich ein etwa spiralförmiger Wickel W bildet. Der Wickel W hat von aussen seitlich betrachtet etwa zylinderförmige Form, wobei sich die Drehachse 8, um die sich ein nicht dargestelltes Bauelement gegenüber einem anderen drehen kann, innerhalb des Wickels angeordnet ist. Hier wird deutlich, dass das eine Ende eines jeden Leiters 3 bzw. jeder Leiterbahn 3 im Inneren des Wickels W und das andere Ende aussen am Wickel W angeordnet ist.

Bei einer Drehung der kleinen starren Leiterplatte 4, zusammen mit einem nicht gezeigten Bauelement, in Richtung des Pfeiles P1 um die Drehachse 8 wird sich die flexible Leiterplatte 1 je nach Drehrichtung weiter auf- oder abwickeln, ohne dass es zu einer wesentlichen Beanspruchung der Anschlussstellen kommt. Der Wickel wird sich dementsprechend weiter zusammenziehen oder öffnen, wobei durchaus auch eine Berührung der flexiblen Leiterplatte 1 mit sich selbst möglich ist, was jedoch aufgrund der sehr glatten Oberfläche der Polyimidfolie 2 kein Problem darstellt.

Mit einer solchen Ausführung der elektrischen Kontaktierung z.B. bei einer Bondmaschine zwischen einem Bondkopf und einem feststehenden Trägerelement sind sehr hohe Zykluszahlen möglich, ohne signifikanten Verschleiß an den elektrischen Zuführungen, die innerhalb der flexiblen Leiterplatte realisiert sind.

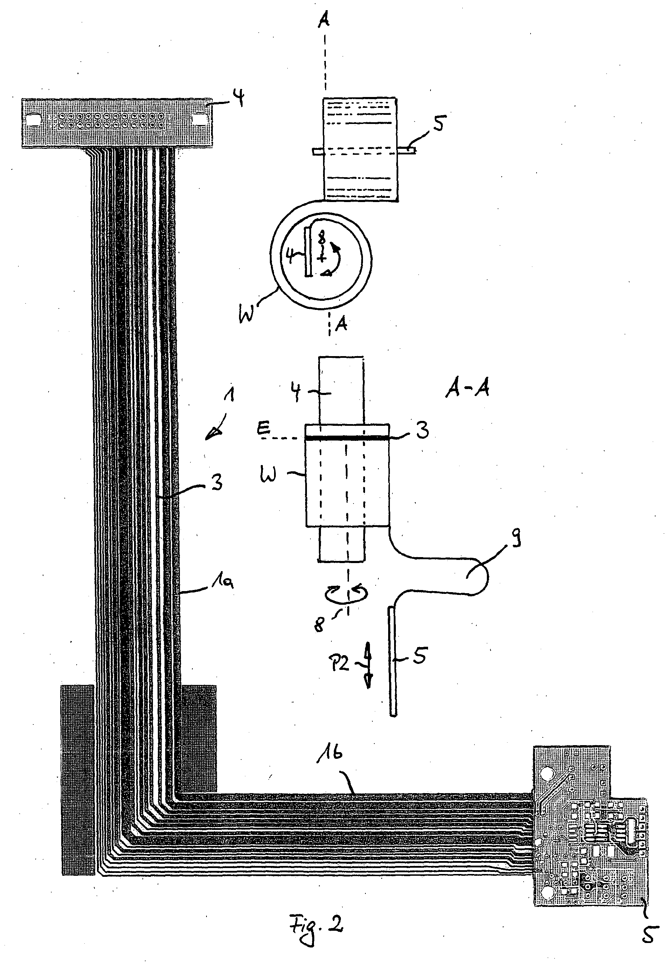

Die Figur 2 zeigt eine weitergebildete Ausführung mit einer zweischenkligen flexiblen Leiterplatte mit den Schenkel 1 a und 1 b, die im vorliegenden Fall unter einem rechten Winkel zueinander orientiert sind, wobei auch andere Winkel möglich sind.

Die flexible Leiterplatte kann z.B. um sich selbst, bzw. um die starre kleine Leiterplatte 4 im Schenkel 1a aufgewickelt werden, um den Wickel W zu bilden, der wiederum eine Rotation der starren Leiterplatte 4 um die Drehachse 8 zulässt. An der kleinen starren Leiterplatte 4 kann z.B. ein drehbarer Bondkopf angeschlossen sein, der mit einem vorspringenden Element in den Wickel W hineinragt. In der seitlichen Darstellung des Schnittes A-A der Figur 2 ist erkennbar, dass eine Leiterbahn 3 innerhalb einer Ebene E aufgewickelt ist, die im wesentlichen senkrecht zur Drehachse 8 angeordnet ist.

Der weitere Schenkel 1 b der flexiblen Leiterplatte 1 kann z.B. in einer Schleife 9 gelegt werden, so dass diese Schleife 9 ein Leitungsreservoir bildet für den Fall, dass eine Translation der beiden starren Leiterplatten 4 und 5 bzw. der daran befestigten Bauelemente stattfinden soll. Diese Translation kann zum Beispiel in der Richtung des Pfeiles P2 erfolgen. Auf diese Weise kann z.B. ein Bondkopf rotatorisch und translatorisch flexibel hinsichtlich seiner elektrischen Kontaktierung angeschlossen werden.

Grundsätzlich besteht keine Notwendigkeit einen zweiten Schenkel 1 b an der flexiblen Leiterplatte 1 vorzusehen, um auch eine Translation zuzulassen. Eine Translation ist auch mit einer Ausführung nach Figur 1 möglich, da sich in diesem Falle der aufgewickelte Wickel teleskopartig auseinanderzieht bzw. wieder zusammenfährt, je nach Translationsrichtung. Die wirkenden Kräfte sind insbesondere bei einer genügend hohen Zahl der Wicklungen gering genug, um eine hohe Standzeit zu garantieren.

## Patentansprüche

1. Anordnung zur elektrischen Kontaktierung zwischen zwei Bauelementen, wobei ein Bauelement gegenüber dem anderen um eine Drehachse rotierbar ist, insbesondere zur elektrischen Kontaktierung eines rotierbaren Bondkopfes an eine Bondmaschine, **dadurch gekennzeichnet, dass** die Bauelemente durch wenigstens einen elektrischen Leiter (3) verbunden sind, der, insbesondere spiralförmig, um die Drehachse (8) gewickelt ist.

2. Anordnung nach Anspruch 1, **dadurch gekennzeichnet, dass** ein Leiter (3) mit seinem innerhalb der Wicklung (W) liegenden Ende das eine Bauelement und mit seinem ausserhalb der Wicklung (W) liegenden Ende das andere Bauelement kontaktiert.

3. Anordnung nach einem der vorherigen Ansprüche, **dadurch gekennzeichnet, dass** die Wicklung (W) eines Leiters (3) innerhalb einer Ebene liegt, die im wesentlichen senkrecht zur Drehachse (8) orientiert ist.

4. Anordnung nach einem der vorherigen Ansprüche, **dadurch gekennzeichnet, dass** ein Leiter (3) als Flachleiter ausgebildet ist, mit einer Breite die größer ist als seine Dicke, wobei sich ein Leiter (3) in seiner Breite in Richtung der Drehachse (8) erstreckt.

5. Anordnung nach einem der vorherigen Ansprüche, **dadurch gekennzeichnet, dass** sie eine Vielzahl von Leitern (3) umfasst, die in axialer Richtung nebeneinander angeordnet sind.

6. Anordnung nach Anspruch 5 , **dadurch gekennzeichnet, dass** die Leiter (3) untereinander isoliert verbunden sind.

7. Anordnung nach einem der vorherigen Ansprüche, **dadurch gekennzeichnet, dass** die Leiter (3) einen, insbesondere freitragenden, zylinderförmigen Wickel (W) bilden, durch den die Drehachse (8) verläuft.

8. Anordnung nach einem der vorherigen Ansprüche, **dadurch gekennzeichnet, dass** die Leiter (3) als Flachbandkabel ausgebildet sind.

9. Anordnung nach einem der vorherigen Ansprüche, **dadurch gekennzeichnet, dass** die Leiter (3) als flexible Leiterplatte (1) ausgebildet sind.

10. Anordnung nach Anspruch 9, **dadurch gekennzeichnet, dass** an wenigstens einem Ende der flexiblen Leiterplatte (1) eine starre Leiterplatte (4,5) angeformt ist zur Verbindung mit einer Bauteil.

11. Anordnung nach einem der vorherigen Ansprüche, **dadurch gekennzeichnet, dass** eine flexible Leiterplatte (1) zweischenklig (1 a, 1b) ausgebildet ist, insbesondere wobei einer der Schenkel (1 a) aufwickelbar ist.

12. Verwendung einer flexiblen Leiterplatte (1) als elektrische Kontaktierung zwischen einem feststehenden Trägerelement einer Bondmaschine und einem relativ dazu rotierbaren Bondkopf.

13. Verwendung nach Anspruch 12, **dadurch gekennzeichnet, dass** die flexible Leiterplatte (1) um die Drechachse des Bondkopfes gewickelt ist.
